(19) Europäisches Patentamt
European Patent Office
Office européen des brevets

(11) **EP 3 845 915 B1**

(12) **EUROPEAN PATENT SPECIFICATION**

(45) Date of publication and mention
of the grant of the patent:
**02.11.2022 Bulletin 2022/44**

(21) Application number: **18933872.6**

(22) Date of filing: **20.09.2018**

(51) International Patent Classification (IPC):
***H01S 5/042*** (2006.01)      ***H01S 5/0239*** (2021.01)
***H01S 5/02212*** (2021.01)      ***H01S 5/02345*** (2021.01)
***H01S 5/062*** (2006.01)      ***H04B 10/50*** (2013.01)

(52) Cooperative Patent Classification (CPC):
(C-Sets available)
**H01S 5/0239; H01L 24/00; H01S 5/0427;**
H01L 2224/48091; H01S 5/02212; H01S 5/02345;
H01S 5/06226; H04B 10/504      (Cont.)

(86) International application number:
**PCT/CN2018/106672**

(87) International publication number:
**WO 2020/056662 (26.03.2020 Gazette 2020/13)**

(54) **PHOTOELECTRON COMPONENT AND MANUFACTURING METHOD THEREFOR**

PHOTOELEKTRONENKOMPONENTE UND HERSTELLUNGSVERFAHREN DAFÜR

COMPOSANT PHOTOÉLECTRONIQUE ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**07.07.2021 Bulletin 2021/27**

(73) Proprietor: **HUAWEI TECHNOLOGIES CO., LTD.
Shenzhen, Guangdong 518129 (CN)**

(72) Inventors:
• **SHI, Wenjun
Shenzhen, Guangdong 518129 (CN)**
• **LI, Zhiwei
Shenzhen, Guangdong 518129 (CN)**
• **ZHANG, Qiang
Shenzhen, Guangdong 518129 (CN)**
• **LI, Xiaohui
Shenzhen, Guangdong 518129 (CN)**
• **ZHOU, Enbo
Shenzhen, Guangdong 518129 (CN)**

(74) Representative: **Maiwald Patent- und
Rechtsanwaltsgesellschaft mbH
Elisenhof
Elisenstraße 3
80335 München (DE)**

(56) References cited:
**CN-A- 104 133 166      CN-A- 105 026 941
CN-A- 107 356 855      CN-A- 107 359 157
JP-A- H1 146 004      US-A1- 2006 176 918
US-A1- 2012 120 472      US-A1- 2018 024 185
US-B1- 6 175 241**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 845 915 B1

(52) Cooperative Patent Classification (CPC): (Cont.)

C-Sets
H01L 2224/48091, H01L 2924/00014

## Description

## TECHNICAL FIELD

This application relates to the field of optoelectronics, and in particular, to an optoelectronic component and a fabrication method thereof.

## BACKGROUND

Packaging an optoelectronic element means forming an optoelectronic component with stable functional performance by the optoelectronic element through electric coupling, device fixation, sealing, or the like. The optoelectronic element may be a laser diode (laser diode, LD), a distributed feedback laser (distributed feedback laser, DFB), an electro-absorption modulated laser (electro-absorption modulated distributed feedback laser, EML), a Fabry-Perot laser (Fabry-Perot laser, FP), or the like.

Because an impedance of the optoelectronic element is relatively low, but a system to which the optoelectronic component formed after packaging the optoelectronic element is applied is a high-impedance network system, there exists a serious impedance mismatch. In other words, there is a relatively large difference value between a bandwidth for transmitting a signal by the optoelectronic component and a bandwidth for transmitting a signal by the optoelectronic element. For example, the bandwidth for transmitting the signal by the optoelectronic element is 25 GHz, while the bandwidth for transmitting the signal by the optoelectronic component is 20 GHz.

In a current solution, a resistor capacitor (resistor capacitor, RC) circuit is connected in parallel between a positive electrode and a negative electrode of an optoelectronic element to increase energy of a high-frequency signal. This implements a function similar to that of a continuous time linear equalizer (continuous time linear equalizer, CTLE), so as to increase an overall signal transmission bandwidth of an optoelectronic component. However, in this solution, because a capacitor and a resistor are used for low-pass filtering, an absolute value of energy of an actual high-frequency signal remains unchanged, but only an energy ratio of the high-frequency signal is increased compared with an energy ratio of a low-frequency signal. Therefore, a bandwidth loss for transmitting a signal by the optoelectronic component is still larger than that in a bandwidth for transmitting a signal by the optoelectronic element.

Optoelectronic elements on a carrier with a resonance circuit for driving the same are known from US 2006/176918 A1, US 2012/ 120472 A1 and JP H11 46004 A.

## SUMMARY

The object of the present invention is solved by a device and a method as defined in the independent claims. Preferred embodiments are defined in the dependent claims.

Embodiments of this application provide an optoelectronic component and a fabrication method thereof. to increase a bandwidth for transmitting a signal by an optoelectronic component formed after packaging.

According to a first aspect, an embodiment of this application provides an optoelectronic component. The optoelectronic component includes a capacitor, an inductor, a carrier component, and an optoelectronic element, where the capacitor, the inductor, and the optoelectronic element are all disposed on the carrier component. The inductor and the capacitor are configured to form a resonant circuit, where a resonance frequency of the resonant circuit is correlated with a signal output frequency of the optoelectronic element. A first electrode of the optoelectronic element is connected to a first electrode of the carrier component through the inductor, and a second electrode of the optoelectronic element is connected to a second electrode of the carrier component. A first electrode of the capacitor is connected to the first electrode of the carrier component, and a second electrode of the capacitor is connected to the second electrode of the carrier component.

In this implementation, the capacitor and the inductor in the optoelectronic component form the resonant circuit; and when the resonance frequency generated by the resonant circuit is made to be relatively close to the signal output frequency of the optoelectronic element by selecting values of the capacitor and the inductor, a resonance signal excites a signal transmitted by the optoelectronic element. This increases a bandwidth for transmitting a signal by the optoelectronic component formed after packaging.

Optionally, in some possible implementations, the inductor includes a wire inductor, the first electrode of the optoelectronic element is connected to one end of the wire inductor, and the other end of the wire inductor is connected to the first electrode of the carrier component. Both ends of the wire inductor are separately connected to the first electrode of the optoelectronic element and the first electrode of the carrier component. This improves feasibility of this solution.

Optionally, in some possible implementations, the inductor includes a wire inductor, the first electrode of the optoelectronic element is connected to one end of the wire inductor, and the other end of the wire inductor is connected to the first electrode of the capacitor. In the implementations of this application, another specific implementation in which the first electrode of the optoelectronic element is connected to the first electrode of the carrier component through the inductor is provided. To be specific, the first electrode of the optoelectronic element is connected to the first electrode of the capacitor through the inductor, and the first electrode of the capacitor is connected to the first electrode of the carrier component. Therefore, the first electrode of the optoelectronic element is also connected to the first electrode of the carrier component. A height of the capacitor is closer to a height of the optoelectronic element. Therefore, a length of the wire inductor connecting the optoelectronic element to the capacitor can be shorter than that of the wire inductor connecting the optoelectronic element to the carrier component. Therefore, the wire inductor used has a shorter length, effectively reducing implementation costs of this solution.

Optionally, in some possible implementations, there are one or more inductors. There may be more than one inductor. Even if an inductor fails, another inductor still works normally. This ensures stability of the optoelectronic component, and improves flexibility of this solution.

Optionally, in some possible implementations, a difference value between the resonance frequency of the resonant circuit and the signal output frequency of the optoelectronic element falls within a preset value range. By ensuring that the resonance frequency of the resonant circuit is relatively close to the signal output frequency of the optoelectronic element, an excitation effect of the resonance signal on the signal transmitted by the optoelectronic element is achieved.

The first electrode of the capacitor and the second electrode of the capacitor are located on a lower surface of the capacitor, the first electrode of the capacitor is attached to the first electrode of the carrier component, and the second electrode of the capacitor is attached to the second electrode of the carrier component. In the capacitor, both electrodes of the capacitor are located on the lower surface of the capacitor, and both electrodes are separately connected to the first electrode and the second electrode of the carrier component in an attachment manner.

Optionally, in some possible implementations, the first electrode of the capacitor and the second electrode of the capacitor are separately located at two ends of the capacitor, the first electrode of the capacitor is attached to the first electrode of the carrier component, and the second electrode of the capacitor is attached to the second electrode of the carrier component. This capacitor structure may be a capacitor formed by a common thin-film through welding, improving practicability of this solution.

Optionally, in some possible implementations, the second electrode of the capacitor is located on a lower surface of the capacitor, the second electrode of the capacitor is attached to the second electrode of the carrier component. The first electrode of the capacitor includes a first conductive plating layer, a second conductive plating layer, and a third conductive plating layer, where the first conductive plating layer is located on the lower surface of the capacitor, the second conductive plating layer is located on an upper surface of the capacitor, and the third conductive plating layer is connected to the first conductive plating layer and the second conductive plating layer. The first conductive plating layer is attached to the first electrode of the carrier component, and the other end of the wire inductor is connected to the second conductive plating layer.

In the implementations of this application, the another capacitor structure is provided. Based on such a capacitor, one end of the inductor is connected to the first electrode of the optoelectronic element, and the other end of the inductor is connected to the upper surface of the capacitor. The first electrode of the capacitor covers both the upper surface and a part of the lower surface, and a part that is of the first electrode and a part that is located on the lower surface of the capacitor is attached to the first electrode of the carrier component. Therefore, the first electrode of the optoelectronic element may also be connected to the first electrode of the carrier component through the inductor. In addition, because the height of the capacitor is closer to the height of the optoelectronic element, the length of the wire inductor connecting the optoelectronic element to the capacitor can be shorter than that of the wire inductor connecting the optoelectronic element to the carrier component. Therefore, the wire inductor used has a shorter length, effectively reducing the implementation costs of this solution.

Optionally, in some possible implementations, the carrier component further includes a drive component, where the drive component includes a drive circuit and a bias circuit. The first electrode of the carrier component is connected to a first electrode of the drive circuit and a first electrode of the bias circuit, and the second electrode of the carrier component is connected to a second electrode of the drive circuit and a second electrode of the bias circuit.

Optionally, in some possible implementations, the carrier component further includes a carrier, an insulation base, a circuit board, a first lead, and a second lead, where the capacitor, the inductor, and the optoelectronic element are all disposed on the carrier, the drive circuit and the bias circuit are disposed on the circuit board, the carrier is fastened on the insulation base, the first electrode of the carrier component is connected to the first electrodes of the drive circuit and the bias circuit that are on the circuit board through the first lead, and the second electrode of the carrier component is connected to the second electrodes of the drive circuit and the bias circuit that are on the circuit board through the second lead.

Optionally, in some possible implementations, TO packaging, COB packaging, or BOX packaging is used for the optoelectronic component. A plurality of possible packaging manners are provided, thereby improving diversity of application scenarios of this solution.

According to a second aspect, an embodiment of this application provides a fabrication method of an optoelectronic component, including:

    providing a carrier component, an optoelectronic element, an inductor, and a capacitor;
    disposing the optoelectronic element and the capacitor on the carrier component;
connecting a first electrode of the optoelectronic element to a first electrode of the carrier component through the inductor, and connecting a second electrode of the optoelectronic element to a second electrode of the carrier component; and
connecting a first electrode of the capacitor to the first electrode of the carrier component, and connecting a second electrode of the capacitor to the second electrode of the carrier component, where the inductor and the capacitor are configured to form a resonant circuit, and a resonance frequency of the resonant circuit is correlated with a signal output frequency of the optoelectronic element.

Optionally, in some possible implementations, the inductor includes a wire inductor. The connecting a first electrode of the optoelectronic element to a first electrode of the carrier component through the inductor includes: connecting the first electrode of the optoelectronic element to one end of the wire inductor, and connecting the other end of the wire inductor to the first electrode of the carrier component.

Optionally, in some possible implementations, the inductor includes a wire inductor. The connecting a first electrode of the optoelectronic element to a first electrode of the carrier component through the inductor includes: connecting the first electrode of the optoelectronic element to one end of the wire inductor, and connecting the other end of the wire inductor to the first electrode of the capacitor.

Optionally, in some possible implementations, there are one or more inductors.

Optionally, in some possible implementations, a difference value between the resonance frequency of the resonant circuit and the signal output frequency of the optoelectronic element falls within a preset value range.

The first electrode of the capacitor and the second electrode of the capacitor are located on a lower surface of the capacitor. The connecting a first electrode of the capacitor to the first electrode of the carrier component, and connecting a second electrode of the capacitor to the second electrode of the carrier component includes: connecting the first electrode of the capacitor to the first electrode of the carrier component in an attachment manner, and attaching the second electrode of the capacitor to the second electrode of the carrier component.

Optionally, in some possible implementations, the first electrode of the capacitor and the second electrode of the capacitor are separately located at two ends of the capacitor. The connecting a first electrode of the capacitor to the first electrode of the carrier component, and connecting a second electrode of the capacitor to the second electrode of the carrier component includes: attaching the first electrode of the capacitor to the first electrode of the carrier component, and attaching the second electrode of the capacitor to the second electrode of the carrier component.

Optionally, in some possible implementations, the second electrode of the capacitor is located on a lower surface of the capacitor, and the first electrode of the capacitor includes a first conductive plating layer, a second conductive plating layer, and a third conductive plating layer, where the first conductive plating layer is located on the lower surface of the capacitor, the second conductive plating layer is located on an upper surface of the capacitor, and the third conductive plating layer is connected to the first conductive plating layer and the second conductive plating layer. The connecting a first electrode of the capacitor to the first electrode of the carrier component, and connecting a second electrode of the capacitor to the second electrode of the carrier component includes: attaching the second electrode of the capacitor to the second electrode of the carrier component, attaching the first conductive plating layer to the first electrode of the carrier component, and connecting the other end of the wire inductor to the second conductive plating layer.

Optionally, in some possible implementations, the carrier component further includes a drive component, where the drive component includes a drive circuit and a bias circuit. The method further includes: connecting the first electrode of the carrier component to a first electrode of the drive circuit and a first electrode of the bias circuit, and connecting the second electrode of the carrier component to a second electrode of the drive circuit and a second electrode of the bias circuit.

Optionally, in some possible implementations, the carrier component further includes a carrier, an insulation base, a circuit board, a first lead, and a second lead. The method further includes:
disposing all of the capacitor, the inductor, and the optoelectronic element on the carrier, disposing the drive circuit and the bias circuit on the circuit board, fastening the carrier on the insulation base, connecting the first electrode of the carrier component to the first electrodes of the drive circuit and the bias circuit that are on the circuit board through the first lead, and connecting the second electrode of the carrier component to the second electrodes of the drive circuit and the bias circuit that are on the circuit board through the second lead.

Optionally, in some possible implementations, transistor outline TO packaging, chip on board COB packaging, or box BOX packaging is used for the optoelectronic component.

It can be learned from the foregoing technical solutions that the embodiments of this application have the following advantages: The capacitor and the inductor in the optoelectronic component form the resonant circuit. When the resonance frequency generated by the resonant circuit is relatively close to the signal output frequency of the optoelectronic element, the resonance signal excites the signal transmitted by the optoelectronic element. This increases the bandwidth for transmitting the signal by the optoelectronic component.

## BRIEF DESCRIPTION OF DRAWINGS

FIG. 1 is a schematic spectrum diagram of signals transmitted by an optoelectronic element;
FIG. 2 is a schematic spectrum diagram of signals transmitted by a device formed after packaging an optoelectronic element in the prior art;
FIG. 3 is a schematic structural diagram of a first type of optoelectronic component according to an embodiment of this application;
FIG. 4 is a schematic diagram of a circuit model of an optoelectronic component according to an embodiment of this application;
FIG. 5 is a schematic structural diagram of a second type of optoelectronic component according to an embodiment of this application;
FIG. 6 is a first schematic structural diagram of a capacitor according to an example useful for the understanding of this application;
FIG. 7 is a schematic structural diagram of a third type of optoelectronic component according to an example useful for the understanding of this application;
FIG. 8 is a second schematic structural diagram of a capacitor according to an embodiment of this application;
FIG. 9 is a third schematic structural diagram of a capacitor according to an embodiment of this application;
FIG. 10 is a fourth schematic structural diagram of a capacitor according to an embodiment of this application;
FIG. 11 is a schematic structural diagram of a fourth type of optoelectronic component according to an embodiment of this application;
FIG. 12 is a schematic structural diagram of a fifth type of optoelectronic component according to an embodiment of this application;
FIG. 13 is a schematic structural diagram of a sixth type of optoelectronic component according to an embodiment of this application; and
FIG. 14 is a schematic diagram of an embodiment of a fabrication method of an optoelectronic component according to an embodiment of this application.

## DESCRIPTION OF EMBODIMENTS

The embodiments of this application provide an optoelectronic component and a fabrication method thereof, to increase a bandwidth for transmitting a signal by an optoelectronic component. It should be noted that the terms "first", "second", "third", "fourth", and the like in the specification, claims, and accompanying drawings of this application are used to distinguish between similar objects, but do not limit a specific sequence or sequence. It should be understood that the data termed in such a way are interchangeable in proper circumstances so that the embodiments of this application can be implemented in other orders than the order illustrated or described herein. Moreover, the terms "include", "have", or any other variant thereof are intended to cover a non-exclusive inclusion. For example, a process, method, system, product, or device that includes a list of steps or units is not necessarily limited to those steps or units, but may include other steps or units not expressly listed or inherent to such a process, method, system, product, or device.

An optoelectronic element in the embodiments of this application may specifically be a semiconductor light emitting diode, a semiconductor laser, or the like that serves as a light source of an information carrier. For example, the optoelectronic element may include a laser diode (laser diode, LD), a directly modulated semiconductor laser (directly modulated semiconductor laser, DML), a distributed feedback laser (distributed feedback laser, DFB), an electro-absorption modulated laser (electro-absorption modulated distributed feedback laser, EML), or a Fabry-Perot laser (Fabry-Perot laser, FP).

The optoelectronic component in the embodiments of this application is a component with stable functional performance that is formed by an optoelectronic element through electric coupling, device fixation, sealing, or the like. Common packaging forms of for the optoelectronic component include transistor outline (transistor outline, TO) packaging, box (BOX) packaging, and chip on board (chip on board, COB) packaging. Specifically, the optoelectronic component may be a transmitter optical subassembly (transmitter optical subassembly, TOSA), a receiver optical subassembly (receiver optical subassembly, ROSA), a bidirectional optical subassembly (bidirectional optical subassembly, BOSA), or the like.

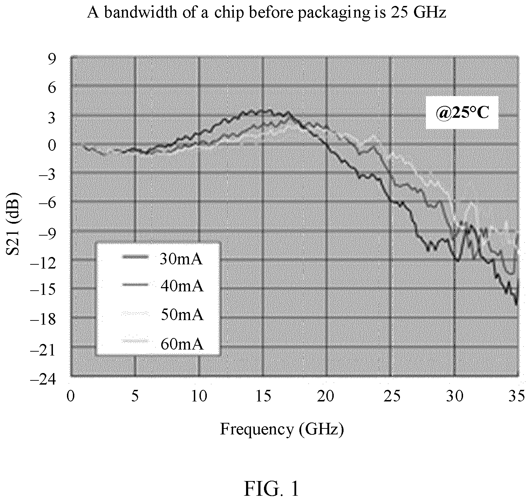

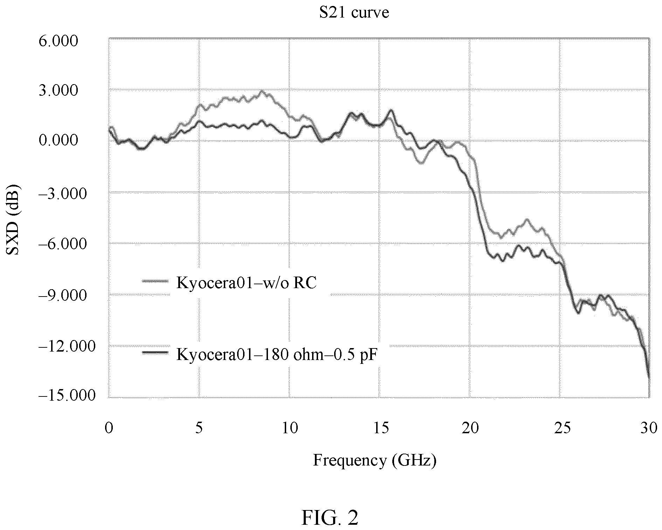

Because an impedance of the optoelectronic element is relatively low, but a system to which the optoelectronic component formed after packaging the optoelectronic element is applied is a high-impedance network system, there exists a serious impedance mismatch. In addition, a size of the optoelectronic element is usually relatively small, and therefore there exists a mode field mismatch during electric coupling. Moreover, various parasitic parameters are introduced due to use of a carrier, a gold wire, a matching network, and the like in a packaging process of the optoelectronic element. In conclusion, there is usually a relatively large difference between a bandwidth for transmitting a signal by the component formed after packaging the optoelectronic element and a bandwidth for transmitting a signal by the optoelectronic element. For example, a 3 dB bandwidth for transmitting a signal by the optoelectronic element before packaging is 25 GHz (as shown in FIG. 1), while a 3 dB bandwidth for transmitting a signal by the optoelectronic component formed by packaging the optoelectronic element is 20 GHz (as shown in FIG. 2) As a result, the bandwidth loss for transmitting a signal by the optoelectronic component is larger than that in a bandwidth of the bandwidth for transmitting a signal by the optoelectronic element.

Therefore, this application provides an optoelectronic component, to increase a bandwidth for transmitting a signal by an optoelectronic component formed after packaging.

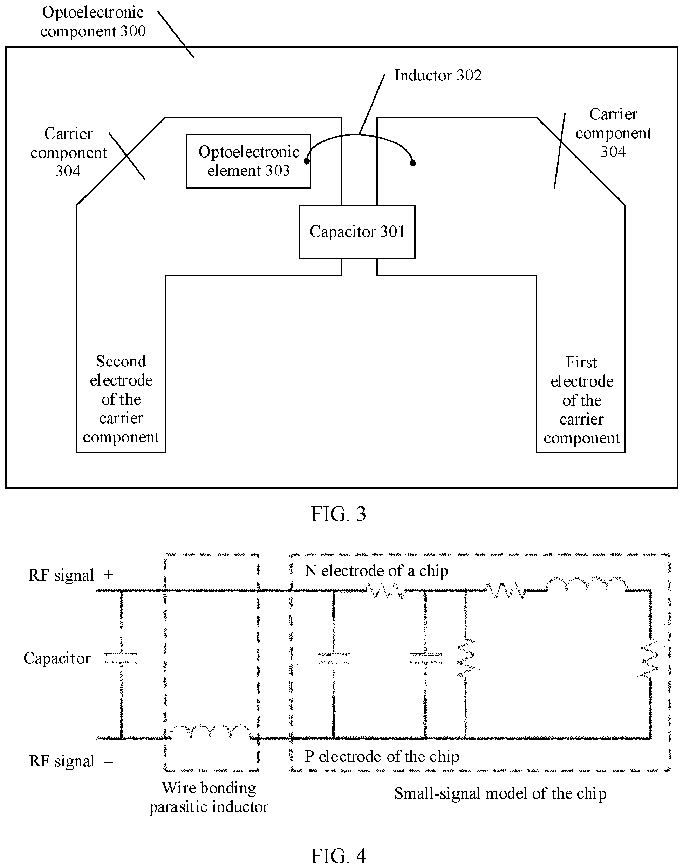

FIG. 3 is a schematic structural diagram of a first type of optoelectronic component according to an embodiment of this application. As shown in FIG. 3, the optoelectronic component 300 includes a capacitor 301, an inductor 302, an optoelectronic element 303, and a carrier component 304. The capacitor 301, the inductor 302, and the optoelectronic element 303 are all disposed on the carrier component 304. It can be understood that each of the capacitor 301, the optoelectronic element 303, and the carrier component 304 includes a positive electrode and a negative electrode. In all the embodiments of this application, a first electrode and a second electrode are used to respectively represent the positive electrode and the negative electrode of each of the foregoing devices. Specifically, if the first electrode represents a positive electrode, the second electrode represents a negative electrode, and vice versa.

The following describes in detail a connection manner between the devices in the optoelectronic component with reference to FIG. 3.

A first electrode of the optoelectronic element 303 is connected to a first electrode of the carrier component 304 through the inductor 302. Specifically, the first electrode of the optoelectronic element 303 is connected to one end of the inductor 302, and the other end of the inductor 302 is connected to the first electrode of the carrier component 304. A second electrode of the optoelectronic element 303 is connected to a second electrode of the carrier component 304. A first electrode and a second electrode of the capacitor 301 are separately connected to the first electrode and the second electrode of the carrier component 304.

It can be understood that the inductor 302 and the capacitor 301 are configured to form a resonant circuit, and a resonance frequency generated by the resonant circuit is correlated with a signal output frequency of the optoelectronic element 303. Specifically, that the resonance frequency is relatively close to the signal output frequency of the optoelectronic element 303 needs to be ensured, that is, a difference value between the resonance frequency and the signal output frequency of the optoelectronic element 303 falls within a preset value range. The preset value range may specifically be plus or minus 5 GHz or a smaller range. If values of the resonance frequency and the signal output frequency of the optoelectronic element 303 are closer to each other, a resonance effect is better.

It should be noted that in this solution, connections between the devices in the optoelectronic component may be direct connections between the devices in a physical location relationship. For example, an electrode located on a lower surface of the optoelectronic element 303 or the capacitor 301 may be connected to an electrode of the carrier component 304 in an attachment manner through welding. Alternatively, connections between the devices in the optoelectronic component may be electrical connections between the devices, that is, different devices may be electrically connected to each other through a connection, where the connection is not necessarily a direct connection in a physical location relationship.

In this embodiment of this application, the capacitor and the inductor in the optoelectronic component form the resonant circuit; and when the resonance frequency generated by the resonant circuit is made to be relatively close to the signal output frequency of the optoelectronic element by selecting values of the capacitor and the inductor, a resonance signal can excite a signal transmitted by the optoelectronic element. This can increase a bandwidth of a bandwidth for transmitting a signal by the optoelectronic component formed after packaging. In addition, no additional load is added to the optoelectronic component, and therefore power consumption of the optoelectronic component is not increased.

Optionally, the inductor 302 may be a wire inductor that may specifically be made of a gold wire. The second electrode of the optoelectronic element 303 may be disposed on the lower surface of the optoelectronic element, the first electrode of the optoelectronic element 303 may be disposed on an upper surface of the optoelectronic element, the lower surface of the optoelectronic element 303 may be connected to the second electrode of the carrier component 304 in an attachment manner, and the upper surface of the optoelectronic element 303 may be connected to the first electrode of the carrier component 304 through wire bonding (wired bonding).

Optionally, there may be one or more inductors 302. When a plurality of inductors are used, one end of each inductor is connected to the first electrode of the optoelectronic element, and the other end of the inductor is connected to the first electrode of the carrier component. This brings an advantage that even if one of the inductors fails, another inductor can still work normally, thereby improving stability of the optoelectronic component.

FIG. 4 is a circuit model diagram according to this application. In FIG. 4, a small-signal model of a chip is a circuit model of the optoelectronic element 303 in this application. Output power of the chip may be calculated according to the following formula:

$$P_{chip}(\omega) = (\frac{R}{R + j\omega L})^2 \times \frac{U_{driver}^2}{R}$$

Output power of the optoelectronic component 300 may be calculated according to the following formula:

$$P'_{chip}(\omega) = (\frac{\frac{1}{j\omega C}}{R + j\omega L + \frac{1}{j\omega C}})^2 \times \frac{U^2_{driver}}{R}$$

$\omega$ is an angular frequency and is equal to $2\pi f$; R is a resistance of the optoelectronic element; and L is an inductance, C is a capacitance, $U_{driver}$ is a fixed drive voltage, and f is a frequency.

A calculation formula of a resonance frequency $f_0$ is as follows:

$$f_0 = \frac{1}{2\pi\sqrt{LC}}$$

When an output frequency of the optoelectronic element is known, the resonance frequency of the resonant circuit is made to be the same as or close to the signal output frequency of the optoelectronic element by selecting values of the inductor and the capacitor. This increases the bandwidth of the bandwidth for transmitting the signal by the optoelectronic component.

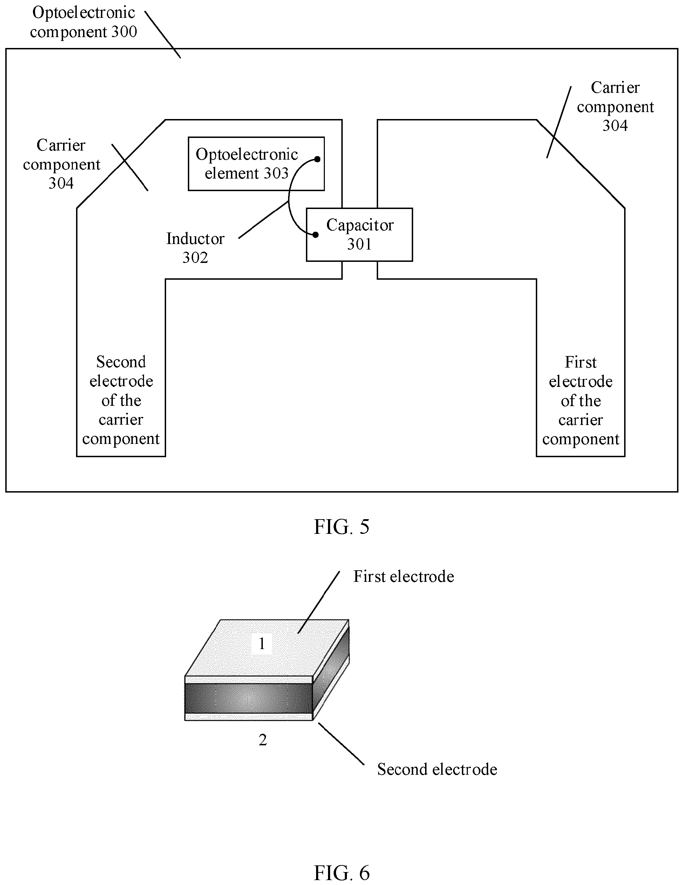

In addition to the connection manner shown in FIG. 3, there may be another connection manner between the devices in the optoelectronic component 300 in the embodiments of this application. FIG. 5 shows a second type of optoelectronic component 300 according to an embodiment of this application. As shown in FIG. 5, the optoelectronic component 300 includes a capacitor 301, an inductor 302, an optoelectronic element 303, and a carrier component 304, where the capacitor 301, the inductor 302, and the optoelectronic element 303 are all disposed on the carrier component 304.

The following describes in detail a connection manner between the devices in the optoelectronic component with reference to FIG. 5.

A first electrode of the optoelectronic element 303 is connected to a first electrode of the carrier component 304 through the inductor 302. Specifically, the first electrode of the optoelectronic element 303 is connected to one end of the inductor 302, and the other end of the inductor 302 is connected to a first electrode of the capacitor 301. A second electrode of the optoelectronic element 303 is connected to a second electrode of the carrier component 304. The first electrode of the capacitor 301 is connected to the first electrode of the carrier component 304, and a second electrode of the capacitor 301 is connected to the second electrode of the carrier component 304.

With reference to the two embodiments shown in FIG. 3 and FIG. 5, the capacitor used in this application may have a plurality of different structures. With reference to several different capacitor structures, the following further describes the embodiments corresponding to FIG. 3 and FIG. 5.

FIG. 6 is a schematic structural diagram of a capacitor according to an example useful for the understanding of this application. In the figure, both an upper surface and a lower surface of the capacitor are plating layers as electrodes, the upper surface is corresponding to a first electrode of the capacitor, the lower surface is corresponding to a second electrode of the capacitor, and a middle part of the capacitor is a dielectric medium.

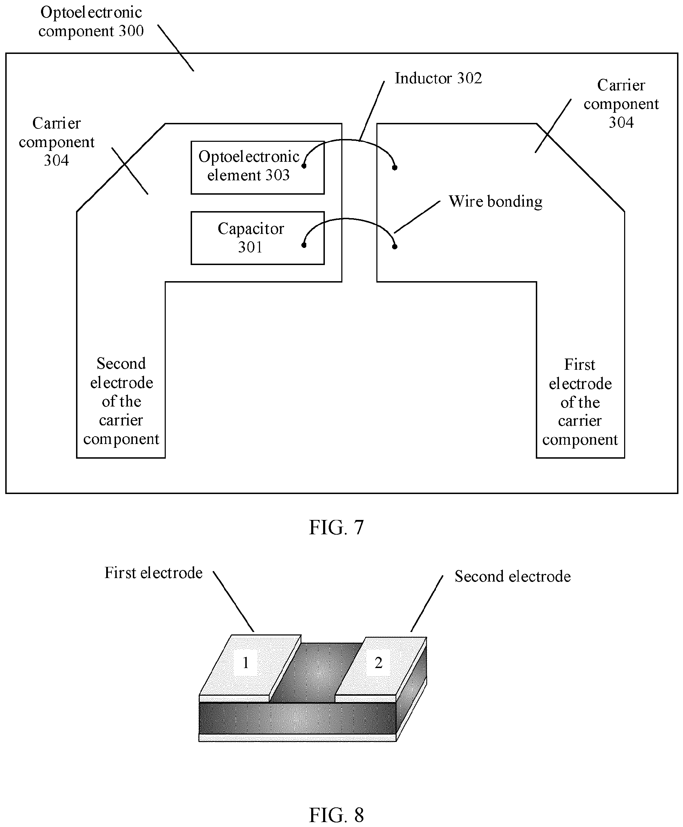

FIG. 7 shows an optoelectronic component 300 according to an example useful for the understanding of the invention and provided with the capacitor structure shown in FIG. 6 The second electrode of the capacitor 301 may be connected to the second electrode of the carrier component 304 in an attachment manner through welding, and the first electrode of the capacitor 301 may be connected to the first electrode of the carrier component 304 through wire bonding.

FIG. 8 is another schematic structural diagram of a capacitor according to an embodiment of this application. As shown in FIG. 8, both a first electrode and a second electrode of the capacitor are located on a surface of the capacitor on a same side. In a possible implementation, the first electrode and the second electrode of the capacitor are separately connected to the first electrode and the second electrode of the carrier component in an attachment manner through welding. This may specifically be corresponding to the implementation shown in FIG. 3. Compared with the capacitor structure shown in FIG. 6, in this capacitor structure shown in FIG. 8, there is no need to perform wire bonding to connect the first electrode of the capacitor to the first electrode of the carrier component, so that a resonance effect generated by the resonant circuit is better.

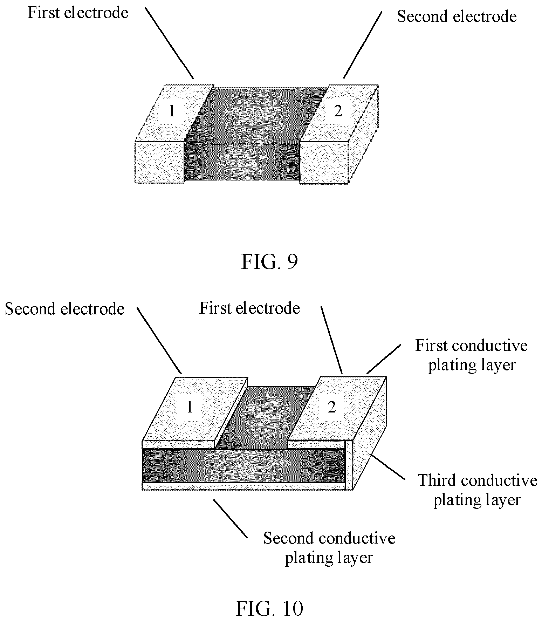

FIG. 9 is another schematic structural diagram of a capacitor according to an embodiment of this application. As shown in FIG. 9, a first electrode and a second electrode of the capacitor are separately located at two ends of the capacitor, and a middle part of the capacitor is a dielectric medium. Different from the capacitor structures, shown in FIG. 6 and FIG. 8, including three layers, namely an upper layer, a middle layer, and a lower layer, FIG. 9 shows a capacitor structure including three layers: , namely a left layer, a middle layer, and a right layer, is shown in FIG. 9. The first electrode of the capacitor may be attached to the first electrode of the carrier component through welding, and the second electrode of the capacitor may also be attached to the second electrode of the carrier component through welding. This may specifically be corresponding to the implementation shown in FIG. 3.

FIG. 10 is another schematic structural diagram of a capacitor according to an embodiment of this application. As shown in FIG. 10, a second electrode of the capacitor is located on one surface of the capacitor, and the second electrode of the capacitor may be attached to the second electrode of the carrier component through welding. The first electrode of the capacitor may be divided into three parts, namely a first conductive plating layer, a second conductive plating layer, and a third conductive plating layer. The first conductive plating layer and the second electrode of the capacitor are located on a same surface, the second conductive plating layer is located on another surface opposite to the first conductive plating layer, and the third conductive plating layer is located on a side surface of the capacitor and is connected to the first conductive plating layer and As a whole, the first conductive plating layer and the second conductive plating layer are electrically connected to each other. Therefore, the first conductive plating layer may be attached to the first electrode of the carrier component through welding, one end of the wire inductor is connected to the first electrode of the optoelectronic element, and the other end of the wire inductor is connected to the second conductive plating layer. In this way, the first electrode of the optoelectronic element and the first electrode of the carrier component are electrically connected to each other. This is specifically corresponding to the implementation shown in FIG. 5.

In the capacitor structure shown in FIG. 10, a height of the capacitor is relatively closer to a height of the optoelectronic element. Therefore, a length of the wire inductor connecting the optoelectronic element to the capacitor can be shorter than that of the wire inductor connecting the optoelectronic element to the carrier component. This effectively reduces implementation costs of the optoelectronic component.

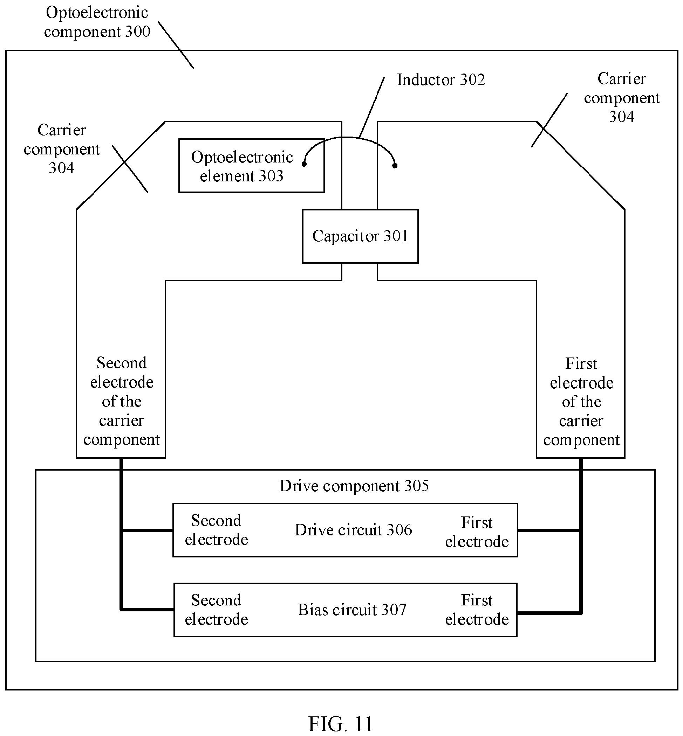

The following further describes composition of the carrier component 304 in the optoelectronic component 300. FIG. 11 shows another optoelectronic component 300 according to an embodiment of this application.

Optionally, the carrier component 304 may further include a drive component 305. The drive component 305 may specifically include a drive circuit 306 and a bias circuit 307. The first electrode of the carrier component 304 is connected to a first electrode of the drive circuit 306 and a first electrode of the bias circuit 307, and the second electrode of the carrier component 304 is connected to a second electrode of the drive circuit 306 and a second electrode of the bias circuit 307.

It should be noted that the optoelectronic element is connected to the capacitor and the inductor, further forming a signal loop with the drive circuit and the bias circuit by using the two electrodes of the carrier component. The bias circuit loads a bias current for the optoelectronic element, so that the optoelectronic element works normally. The drive circuit sends a high-speed radio-frequency signal, and loads the high-speed radio-frequency signal to the optoelectronic element through a positive electrode and a negative electrode of the carrier component, so that the optoelectronic element transmits the high-speed radio-frequency signal.

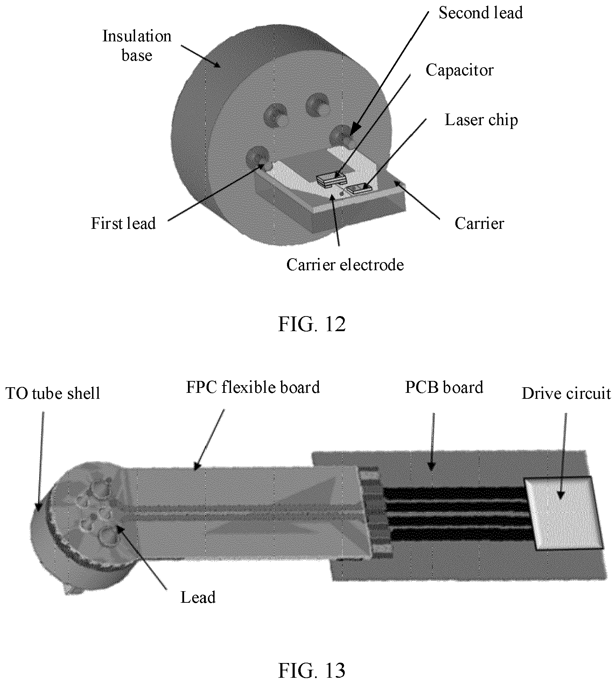

With reference to FIG. 12 and FIG. 13, the following further describes the optoelectronic component shown in FIG. 11. Optionally, the carrier component may specifically include a carrier, an insulation base (a tube shell), a circuit board, a first lead, and a second lead. The capacitor, the inductor, and the optoelectronic element are all disposed on the carrier, the carrier is fastened on the insulation base, the first electrode of the carrier component is connected to the first electrodes of the drive circuit and the bias circuit that are on the circuit board through the first lead, and the second electrode of the carrier component is connected to the second electrodes of the drive circuit and the bias circuit that are on the circuit board through the second lead.

It should be noted that the leads in the carrier component include but are not limited to the first lead and the second lead. Both the drive circuit and the bias circuit may be disposed on the circuit board. As shown in FIG. 12, the circuit board may be placed inside the tube shell provided by the insulation base.

Optionally, the circuit board may extend out from an inner part of the tube shell provided by the insulation base. As shown in FIG. 13, the circuit board may include a flexible printed circuit (flexible printed circuit, FPC) and/or a printed circuit board (printed circuit board, PCB).

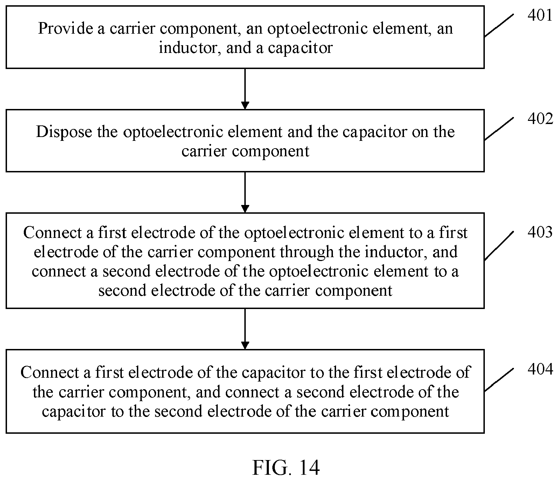

FIG. 14 shows a fabrication method of an optoelectronic component according to an embodiment of this application. As shown in FIG. 14, the method includes the following steps.

401. Provide a carrier component, an optoelectronic element, an inductor, and a capacitor.

402. Dispose the optoelectronic element and the capacitor on the carrier component.

403. Connect a first electrode of the optoelectronic element to a first electrode of the carrier component through the inductor, and connect a second electrode of the optoelectronic element to a second electrode of the carrier component.

404. Connect a first electrode of the capacitor to the first electrode of the carrier component, and connect a second electrode of the capacitor to the second electrode of the carrier component.

In this embodiment of this application, the capacitor and the inductor are configured to form a resonant circuit; and when a resonance frequency generated by the resonant circuit is made to be relatively close to a signal output frequency of the optoelectronic element by selecting values of the capacitor and the inductor, a resonance signal excites a signal transmitted by the optoelectronic element. This increases a bandwidth of a bandwidth for transmitting a signal by the optoelectronic component formed after packaging.

It should be noted that a sequence of the foregoing processing steps is not specifically limited in this application. Specifically, in this embodiment of this application, the optoelectronic component may be fabricated according to the structures of the optoelectronic components in the embodiments shown in FIG. 3 to FIG. 13. Details are not described herein again.

It should be noted that the foregoing embodiments are merely intended to describe the technical solutions of this application other than to limit this application.

## Claims

1. An optoelectronic component (300), comprising: a capacitor (301), an inductor (302), a carrier component (304), component, and an optoelectronic element (303), wherein:

   the capacitor, the inductor, and the optoelectronic element are all disposed on the carrier component;
   the inductor and the capacitor are configured to form a resonant circuit, wherein a resonance frequency of the resonant circuit is correlated with a signal output frequency of the optoelectronic element;
   the resonance frequency is made to be relatively close to the signal output frequency and a resonance signal excites a signal transmitted by the optoelectronic element;
   a first electrode of the optoelectronic element is connected to a first electrode of the carrier component through the inductor, and a second electrode of the optoelectronic element is connected to a second electrode of the carrier component; and
   a first electrode (1) of the capacitor (301) is connected to the first electrode of the carrier component, and a second electrode (2) of the capacitor is connected to the second electrode of the carrier component; **characterized in that** both the first electrode of the capacitor and the second electrode of the capacitor are located on a lower surface of the capacitor, the first electrode of the capacitor is attached to the first electrode of the carrier component, and the second electrode of the capacitor is attached to the second electrode of the carrier component.

2. The optoelectronic component according to claim 1, wherein the inductor comprises a wire inductor, the first electrode of the optoelectronic element is connected to one end of the wire inductor, and the other end of the wire inductor is connected to the first electrode of the carrier component.

3. The optoelectronic component according to claim 1, wherein the inductor comprises a wire inductor, the first electrode of the optoelectronic element is connected to one end of the wire inductor, and the other end of the wire inductor is connected to the first electrode of the capacitor.

4. The optoelectronic component according to any one of claims 1 to 3, wherein a difference value between the resonance frequency of the resonant circuit and the signal output frequency of the optoelectronic element falls within a preset value range; or the resonance frequency of the resonant circuit is equal to the signal output frequency of the optoelectronic element.

5. The optoelectronic component according to claim 1 or 2, wherein the first electrode of the capacitor and the second electrode of the capacitor are separately located at two ends of the capacitor.

6. The optoelectronic component according to claim 1 or 3, wherein the first electrode of the capacitor comprises a first conductive plating layer, a second conductive plating layer, and a third conductive plating layer, wherein the first conductive plating layer is located on the lower surface of the capacitor, the second conductive plating layer is located on an upper surface of the capacitor, and the third conductive plating layer is connected to the first conductive plating layer and the second conductive plating layer; and the first conductive plating layer is attached to the first electrode of the carrier component, and the other end of the wire inductor is connected to the second conductive plating layer.

7. The optoelectronic component according to any one of claims 1 to 3, wherein the carrier component further comprises a drive component, and the drive component comprises a drive circuit and a bias circuit; and the first electrode of the carrier component is connected to a first electrode of the drive circuit and a first electrode of the bias circuit, and the second electrode of the carrier component is connected to a second electrode of the drive circuit and a second electrode of the bias circuit.

8. The optoelectronic component according to claim 7, wherein the carrier component further comprises a carrier, an insulation base, a circuit board, a first lead, and a second lead, wherein:
   the capacitor, the inductor, and the optoelectronic element are all disposed on the carrier, the drive circuit and the bias circuit are disposed on the circuit board, the carrier is fastened on the insulation base, the first electrode of the carrier component is connected to the first electrodes of the drive circuit and the bias circuit that are on the circuit board through the first lead, and the second electrode of the carrier component is connected to the second electrodes of the drive circuit and the bias circuit that are on the circuit board through the second lead.

9. The optoelectronic component according to any one of claims 1 to 8, wherein TO packaging, COB packaging, or BOX packaging is used for the optoelectronic component.

10. A fabrication method of an optoelectronic component (300), wherein the method comprises:

providing a carrier component (304), an optoelectronic element (303), an inductor (302), and a cpacitor (301);

disposing the optoelectronic element and the capacitor on the carrier component;

connecting a first electrode of the optoelectronic element to a first electrode of the carrier component through the inductor, and connecting a second electrode of the optoelectronic element to a second electrode of the carrier component; and

connecting a first electrode (1) of the capacitor (301) to the first electrode of the carrier component, and connecting a second electrode (2) of the capacitor to the second electrode of the carrier component, wherein the inductor and the capacitor are configured to form a resonant circuit, and a resonance frequency of the resonant circuit is correlated with a signal output frequency of the optoelectronic element;

the resonance frequency is made to be relatively close to the signal output frequency and a resonance signal excites a signal transmitted by the optoelectronic element; and

wherein both the first electrode of the capacitor and the second electrode of the capacitor are located on a lower surface of the capacitor; and the connecting a first electrode of the capacitor to the first electrode of the carrier component, and connecting a second electrode of the capacitor to the second electrode of the carrier component comprises:

attaching the first electrode of the capacitor to the first electrode of the carrier component, and attaching the second electrode of the capacitor to the second electrode of the carrier component.

11. The method according to claim 10, wherein the inductor comprises a wire inductor, and the connecting a first electrode of the optoelectronic element to a first electrode of the carrier component through the inductor comprises:

connecting the first electrode of the optoelectronic element to one end of the wire inductor, and connecting the other end of the wire inductor to the first electrode of the carrier component.

12. The method according to claim 10, wherein the inductor comprises a wire inductor, and the connecting a first electrode of the optoelectronic element to a first electrode of the carrier component through the inductor comprises:

connecting the first electrode of the optoelectronic element to one end of the wire inductor, and connecting the other end of the wire inductor to the first electrode of the capacitor.

13. The method according to any one of claims 10 to 12, wherein a difference value between the resonance frequency of the resonant circuit and the signal output frequency of the optoelectronic element falls within a preset value range; or the resonance frequency of the resonant circuit is equal to the signal output frequency of the optoelectronic element.

**Patentansprüche**

1. Optoelektronische Komponente (300), umfassend: einen Kondensator (301), eine Spule (302), eine Trägerkomponente (304), eine Komponente und ein optoelektronisches Element (303), wobei:

der Kondensator, die Spule und das optoelektronische Element alle auf der Trägerkomponente angeordnet sind;

die Spule und der Kondensator so konfiguriert sind, dass sie einen Resonanzkreis bilden, wobei eine Resonanzfrequenz des Resonanzkreises mit einer Signalausgangsfrequenz des optoelektronischen Elements korreliert ist;

die Resonanzfrequenz relativ nahe bei der Signalausgangsfrequenz liegt und ein Resonanzsignal ein durch das optoelektronische Element übertragenes Signal anregt;

eine erste Elektrode des optoelektronischen Elements über die Spule mit einer ersten Elektrode der Trägerkomponente verbunden ist und eine zweite Elektrode des optoelektronischen Elements mit einer zweiten Elektrode der Trägerkomponente verbunden ist; und

eine erste Elektrode (1) des Kondensators (301) mit der ersten Elektrode der Trägerkomponente verbunden ist und eine zweite Elektrode (2) des Kondensators mit der zweiten Elektrode der Trägerkomponente verbunden ist;

**dadurch gekennzeichnet, dass**

sowohl die erste Elektrode des Kondensators als auch die zweite Elektrode des Kondensators auf einer unteren Oberfläche des Kondensators angeordnet sind, die erste Elektrode des Kondensators an der ersten Elektrode der Trägerkomponente angebracht ist und die zweite Elektrode des Kondensators an der zweiten Elektrode der Trägerkomponente angebracht ist.

2. Optoelektronische Komponente nach Anspruch 1, wobei die Spule eine Drahtspule umfasst, die erste Elektrode des optoelektronischen Elements mit einem Ende der Drahtspule verbunden ist und das andere Ende der Drahtspule mit der ersten Elektrode der Trägerkomponente verbunden ist.

3. Optoelektronische Komponente nach Anspruch 1, wobei die Spule eine Drahtspule umfasst, die erste Elektrode des optoelektronischen Elements mit einem Ende der Drahtspule verbunden ist und das andere Ende der Drahtspule mit der ersten Elektrode des Kondensators verbunden ist.

4. Optoelektronische Komponente nach einem der Ansprüche 1 bis 3, wobei ein Differenzwert zwischen der Resonanzfrequenz des Resonanzkreises und der Signalausgangsfrequenz des optoelektronischen Elements in einen voreingestellten Wertebereich fällt; oder die Resonanzfrequenz des Resonanzkreises gleich der Signalausgangsfrequenz des optoelektronischen Elements ist.

5. Optoelektronische Komponente nach Anspruch 1 oder 2, wobei die erste Elektrode des Kondensators und die zweite Elektrode des Kondensators separat an zwei Enden des Kondensators angeordnet sind.

6. Optoelektronische Komponente nach Anspruch 1 oder 3, wobei die erste Elektrode des Kondensators eine erste leitfähige Plattierungsschicht, eine zweite leitfähige Plattierungsschicht und eine dritte leitfähige Plattierungsschicht umfasst, wobei die erste leitfähige Plattierungsschicht auf der unteren Oberfläche des Kondensators angeordnet ist, die zweite leitfähige Plattierungsschicht auf einer oberen Oberfläche des Kondensators angeordnet ist und die dritte leitfähige Plattierungsschicht mit der ersten leitfähigen Plattierungsschicht und der zweiten leitfähigen Plattierungsschicht verbunden ist; und die erste leitfähige Plattierungsschicht an der ersten Elektrode der Trägerkomponente angebracht ist und das andere Ende der Drahtspule mit der zweiten leitfähigen Plattierungsschicht verbunden ist.

7. Optoelektronische Komponente nach einem der Ansprüche 1 bis 3, wobei die Trägerkomponente ferner eine Treiberkomponente umfasst und die Treiberkomponente eine Treiberschaltung und eine Vorspannungsschaltung umfasst; und die erste Elektrode der Trägerkomponente mit einer ersten Elektrode der Treiberschaltung und einer ersten Elektrode der Vorspannungsschaltung verbunden ist und die zweite Elektrode der Trägerkomponente mit einer zweiten Elektrode der Treiberschaltung und einer zweiten Elektrode der Vorspannungsschaltung verbunden ist.

8. Optoelektronische Komponente nach Anspruch 7, wobei die Trägerkomponente ferner einen Träger, eine Isolierunterteil, eine Leiterplatte, einen ersten Leiter und einen zweiten Leiter umfasst, wobei: der Kondensator, die Spule und das optoelektronische Element alle auf dem Träger angeordnet sind, die Treiberschaltung und die Vorspannungsschaltung auf der Leiterplatte angeordnet sind, der Träger auf dem Isolierunterteil befestigt ist, die erste Elektrode der Trägerkomponente mit den ersten Elektroden der Treiberschaltung und der Vorspannungsschaltung, die sich auf der Leiterplatte befinden, durch die erste Leitung verbunden ist und die zweite Elektrode der Trägerkomponente mit den zweiten Elektroden der Treiberschaltung und der Vorspannungsschaltung, die sich auf der Leiterplatte befinden, durch die zweite Leitung verbunden ist.

9. Optoelektronische Komponente nach einem der Ansprüche 1 bis 8, wobei für die optoelektronische Komponente ein TO-Gehäuse, COB-Gehäuse oder ein BOX-Gehäuse verwendet wird.

10. Herstellungsverfahren für eine optoelektronische Komponente (300), wobei das Verfahren umfasst:

   Bereitstellen einer Trägerkomponente (304), eines optoelektronischen Elements (303), einer Spule (302) und eines Kondensators (301); Anordnen des optoelektronischen Elements und des Kondensators auf der Trägerkomponente; Verbinden einer ersten Elektrode des optoelektronischen Elements mit einer ersten Elektrode der Trägerkomponente durch die Spule und Verbinden einer zweiten Elektrode des optoelektronischen Elements mit einer zweiten Elektrode der Trägerkomponente; und Verbinden einer ersten Elektrode (1) des Kondensators (301) mit der ersten Elektrode der Trägerkomponente und Verbinden einer zweiten Elektrode (2) des Kondensators mit der zweiten Elektrode der Trägerkomponente, wobei die Spule und der Kondensator so konfiguriert sind, dass sie einen Resonanzkreis bilden und eine Resonanzfrequenz des Resonanzkreises mit einer Signalausgangsfrequenz des optoelektronischen Elements korreliert ist; die Resonanzfrequenz relativ nahe bei der Signalausgangsfrequenz liegt und ein Resonanzsignal ein durch das optoelektronische Element übertragenes Signal anregt; und wobei sowohl die erste Elektrode des Kondensators als auch die zweite Elektrode des Kondensators auf einer unteren Oberfläche des Kondensators angeordnet sind; und das Verbinden einer ersten Elektrode des Kondensators mit der ersten Elektrode der Trägerkomponente und das Verbinden einer zweiten Elektrode des Kondensators mit der zweiten Elektrode der Trägerkomponente umfasst: Anbringen der ersten Elektrode des Kondensators an der ersten Elektrode der Trägerkomponente und Anbringen der zweiten Elektrode des Kondensators an der zweiten Elektrode der Trägerkomponente.

**11.** Verfahren nach Anspruch 10, wobei die Spule eine Drahtspule umfasst und das Verbinden einer ersten Elektrode des optoelektronischen Elements mit einer ersten Elektrode der Trägerkomponente durch die Spule umfasst:
Verbinden der ersten Elektrode des optoelektronischen Elements mit einem Ende der Drahtspule und Verbinden des anderen Endes der Drahtspule mit der ersten Elektrode der Trägerkomponente.

**12.** Verfahren nach Anspruch 10, wobei die Spule eine Drahtspule umfasst und das Verbinden einer ersten Elektrode des optoelektronischen Elements mit einer ersten Elektrode der Trägerkomponente durch die Spule umfasst:
Verbinden der ersten Elektrode des optoelektronischen Elements mit einem Ende der Drahtspule und Verbinden des anderen Endes der Drahtspule mit der ersten Elektrode des Kondensators.

**13.** Verfahren nach einem der Ansprüche 10 bis 12, wobei ein Differenzwert zwischen der Resonanzfrequenz des Resonanzkreises und der Signalausgangsfrequenz des optoelektronischen Elements in einen voreingestellten Wertebereich fällt; oder die Resonanzfrequenz des Resonanzkreises gleich der Signalausgangsfrequenz des optoelektronischen Elements ist.

**Revendications**

**1.** Composant optoélectronique (300), comprenant : un condensateur (301), un inducteur (302), un composant de support (304), un composant et un élément optoélectronique (303), dans lequel :

le condensateur, l'inducteur et l'élément optoélectronique sont tous disposés sur le composant de support ;
l'inducteur et le condensateur sont configurés pour former un circuit résonnant, dans lequel une fréquence de résonance du circuit résonnant est corrélée avec une fréquence de sortie de signal de l'élément optoélectronique ;
la fréquence de résonance est rendue relativement proche de la fréquence de sortie de signal et un signal de résonance excite un signal émis par l'élément optoélectronique ;
une première électrode de l'élément optoélectronique est connectée à une première électrode du composant de support par le biais de l'inducteur, et une seconde électrode de l'élément optoélectronique est connectée à une seconde électrode du composant de support ; et
une première électrode (1) du condensateur (301) est connectée à la première électrode du composant de support, et une seconde électrode (2) du condensateur est connectée à la seconde électrode du composant de support ;
**caractérisé en ce que**
à la fois la première électrode du condensateur et la seconde électrode du condensateur sont situées sur une surface inférieure du condensateur, la première électrode du condensateur est fixée à la première électrode du composant de support, et la seconde électrode du condensateur est fixée à la seconde électrode du composant de support.

**2.** Composant optoélectronique selon la revendication 1, dans lequel l'inducteur comprend un inducteur à fil, la première électrode de l'élément optoélectronique est connectée à une extrémité de l'inducteur à fil, et l'autre extrémité de l'inducteur à fil est connectée à la première électrode du composant de support.

**3.** Composant optoélectronique selon la revendication 1, dans lequel l'inducteur comprend un inducteur à fil, la première électrode de l'élément optoélectronique est connectée à une extrémité de l'inducteur à fil, et l'autre extrémité de l'inducteur à fil est connectée à la première électrode du condensateur.

**4.** Composant optoélectronique selon l'une quelconque des revendications 1 à 3, dans lequel une valeur de différence entre la fréquence de résonance du circuit résonnant et la fréquence de sortie de signal de l'élément optoélectronique se situe dans une plage de valeurs prédéfinie ; ou la fréquence de résonance du circuit résonant est égale à la fréquence de sortie de signal de l'élément optoélectronique.

**5.** Composant optoélectronique selon la revendication 1 ou 2, dans lequel la première électrode du condensateur et la seconde électrode du condensateur sont situées séparément aux deux extrémités du condensateur.

**6.** Composant optoélectronique selon la revendication 1 ou 3, dans lequel la première électrode du condensateur comprend une première couche de placage conductrice, une deuxième couche de placage conductrice et une troisième couche de placage conductrice, dans lequel la première couche de placage conductrice est située sur la surface inférieure du condensateur, la deuxième couche de placage conductrice est située sur une surface supérieure du condensateur, et la troisième couche de placage conductrice est connectée à la première couche de placage conductrice et la deuxième couche de placage conductrice ; et la première couche de placage conductrice est fixée à la première électrode du composant de support, et l'autre extrémité de l'inducteur à fil est connectée à la deuxième couche de placage

**7.** Composant optoélectronique selon l'une quelconque des revendications 1 à 3, dans lequel le composant de support comprend en outre un composant de commande, et le composant de commande comprend un circuit de commande et un circuit de polarisation ; et la première électrode du composant de support est connectée à une première électrode du circuit de commande et à une première électrode du circuit de polarisation, et la seconde électrode du composant de support est connectée à une seconde électrode du circuit de commande et une seconde électrode du circuit de polarisation.

**8.** Composant optoélectronique selon la revendication 7, dans lequel le composant de support comprend en outre un support, une base isolante, une carte de circuit, un premier conducteur et un second conducteur, dans lequel :

le condensateur, l'inducteur et l'élément optoélectronique sont tous disposés sur le support, le circuit de commande et le circuit de polarisation sont disposés sur la carte de circuit, le support est fixé sur la base isolante, la première électrode du composant de support est connectée aux premières électrodes du circuit de commande et du circuit de polarisation qui se trouvent sur la carte de circuit par le biais du premier conducteur, et la seconde électrode du composant de support est connectée aux secondes électrodes du circuit de commande et du circuit de polarisation qui se trouvent sur la carte de circuit par le biais du second conducteur.

**9.** Composant optoélectronique selon l'une quelconque des revendications 1 à 8, dans lequel un emballage TO, un emballage COB ou un emballage BOX est utilisé pour le composant optoélectronique.

**10.** Procédé de fabrication d'un composant optoélectronique (300), dans lequel le procédé comprend :

la fourniture d'un composant de support (304), d'un élément optoélectronique (303), d'un inducteur (302) et d'un condensateur (301) ; la disposition de l'élément optoélectronique et du condensateur sur le composant de support ; la connexion d'une première électrode de l'élément optoélectronique à une première électrode du composant de support par le biais de l'inducteur, et la connexion d'une seconde électrode de l'élément optoélectronique à une seconde électrode du composant de support ; et la connexion d'une première électrode (1) du condensateur (301) à la première électrode du composant de support, et la connexion d'une seconde électrode (2) du condensateur à la seconde électrode du composant de support, dans lequel l'inducteur et le condensateur sont configurés pour former un circuit résonnant, et une fréquence de résonance du circuit résonnant est corrélée avec une fréquence de sortie de signal de l'élément optoélectronique ;

la fréquence de résonance est rendue relativement proche de la fréquence de sortie de signal et un signal de résonance excite un signal émis par l'élément optoélectronique ; et

dans lequel à la fois la première électrode du condensateur et la seconde électrode du condensateur sont situées sur une surface inférieure du condensateur ; et la connexion d'une première électrode du condensateur à la première électrode du composant de support, et la connexion d'une seconde électrode du condensateur à la seconde électrode du composant de support comprend :

la fixation de la première électrode du condensateur à la première électrode du composant de support, et la fixation de la seconde électrode du condensateur à la seconde électrode du composant de support.

**11.** Procédé selon la revendication 10, dans lequel l'inducteur comprend un inducteur à fil, et la connexion d'une première électrode de l'élément optoélectronique à une première électrode du composant de support par le biais de l'inducteur comprend : la connexion de la première électrode de l'élément optoélectronique à une extrémité de l'inducteur à fil, et la connexion de l'autre extrémité de l'inducteur à fil à la première électrode du composant de support.

**12.** Procédé selon la revendication 10, dans lequel l'inducteur comprend un inducteur à fil, et la connexion d'une première électrode de l'élément optoélectronique à une première électrode du composant de support par le biais de l'inducteur comprend : la connexion de la première électrode de l'élément optoélectronique à une extrémité de l'inducteur à fil, et la connexion de l'autre extrémité de l'inducteur à fil à la première électrode du condensateur.

**13.** Procédé selon l'une quelconque des revendications 10 à 12, dans lequel une valeur de différence entre la fréquence de résonance du circuit résonnant et la fréquence de sortie de signal de l'élément optoélectronique se situe dans une plage de valeurs prédéfinie ; ou la fréquence de résonance du circuit résonant est égale à la fréquence de sortie de signal de l'élément optoélectronique.

A bandwidth of a chip before packaging is 25 GHz

FIG. 1

S21 curve

FIG. 2

Optoelectronic
component 300

Inductor 302

Carrier
component
304

Carrier
component
304

Optoelectronic
element 303

Capacitor 301

Second
electrode
of the
carrier
component

First
electrode
of the
carrier
component

FIG. 3

RF signal +

N electrode of a chip

Capacitor

P electrode of the chip

RF signal −

Wire bonding
parasitic inductor

Small-signal model of the chip

FIG. 4

Optoelectronic
component 300

Carrier
component
304

Carrier
component
304

Optoelectronic
element 303

Capacitor
301

Inductor
302

Second
electrode
of the
carrier
component

First
electrode
of the
carrier
component

FIG. 5

First electrode

1

2

Second electrode

FIG. 6

Optoelectronic
component 300

Inductor 302

Carrier
component
304

Carrier
component
304

Optoelectronic
element 303

Wire bonding

Capacitor
301

Second
electrode
of the
carrier
component

First
electrode
of the
carrier
component

FIG. 7

First electrode

Second electrode

1

2

FIG. 8

First electrode

Second electrode

FIG. 9

Second electrode

First electrode

First conductive
plating layer

Third conductive
plating layer

Second conductive
plating layer

FIG. 10

FIG. 11

FIG. 12

FIG. 13

| Provide a carrier component, an optoelectronic element, an inductor, and a capacitor | 401 |

| Dispose the optoelectronic element and the capacitor on the carrier component | 402 |

| Connect a first electrode of the optoelectronic element to a first electrode of the carrier component through the inductor, and connect a second electrode of the optoelectronic element to a second electrode of the carrier component | 403 |

| Connect a first electrode of the capacitor to the first electrode of the carrier component, and connect a second electrode of the capacitor to the second electrode of the carrier component | 404 |

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006176918 A1
- US 2012120472 A1

- JP H1146004 A